(19)

**Europäisches Patentamt**

**European Patent Office**

**Office européen des brevets**

(11) **EP 4 629 278 A1**

(12) **EUROPEAN PATENT APPLICATION**

(43) Date of publication:
08.10.2025 Bulletin 2025/41

(21) Application number: **25164549.5**

(22) Date of filing: **18.03.2025**

(51) International Patent Classification (IPC):
**H01J 37/147** (2006.01)   **H01J 37/244** (2006.01)
**H01J 37/26** (2006.01)

(52) Cooperative Patent Classification (CPC):
**H01J 37/222; H01J 37/26;** H01J 37/1471;
H01J 2237/21; H01J 2237/221; H01J 2237/24455;
H01J 2237/24514

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.03.2024 JP 2024051150**

(71) Applicant: **JEOL Ltd.**
**Akishima, Tokyo 196-8558 (JP)**

(72) Inventor: **HISADA, Shota**
**Tokyo, 196-8558 (JP)**

(74) Representative: **Boult Wade Tennant LLP**
**Salisbury Square House**
**8 Salisbury Square**
**London EC4Y 8AP (GB)**

(54) **TRANSMISSION ELECTRON MICROSCOPE, IMAGE CLASSIFICATION METHOD, AND ELECTRON BEAM ADJUSTING METHOD**

(57)   A transmission electron microscope includes: an illumination system (20) that illuminates a specimen (2) with an electron beam; an imaging system (30) that forms an image using the electron beam that has been transmitted through the specimen (2); a detector (50) that captures the image formed by the imaging system (30); and an arithmetic unit (602) that classifies the image captured by the detector (50), the arithmetic unit (602) performing: a process of acquiring a first image captured by the detector (50); a process of calculating an average value and a standard deviation of first pixel values of a plurality of first pixels composing the first image; a process of acquiring information of an average value and a standard deviation of second pixel values of a plurality of second pixels composing a second image captured in a state in which no electron beam is detected by the detector (50); and a process of classifying the first image based on the average value and the standard deviation of the first pixel values and the average value and the standard deviation of the second pixel values.

FIG. 4

**Description**

BACKGROUND OF THE INVENTION

Field of the Invention

The present invention relates to a transmission electron microscope, an image classification method, and an electron beam adjusting method.

Description of Related Art

In a transmission electron microscope, before a specimen image is observed, an optical system is adjusted. For example, in JP 2002-134048 A, a transmission electron microscope including an automatic adjustment device automatically performing adjustment of an optical system is disclosed.

When adjustment of an optical system is performed using a transmission electron microscope, it is necessary to display an image that is optimal for adjustment. For this reason, a user classifies a displayed image based on experiences, and an image that is optimal for adjustment of the optical system is displayed.

SUMMARY OF THE INVENTION

According to a first aspect of the present disclosure, there is provided a transmission electron microscope including:

an illumination system that illuminates a specimen with an electron beam;
an imaging system that forms an image using the electron beam that has been transmitted through the specimen;
a detector that captures the image formed by the imaging system; and
an arithmetic unit that classifies the image captured by the detector,
the arithmetic unit performing:
a process of acquiring a first image captured by the detector;
a process of calculating an average value and a standard deviation of first pixel values of a plurality of first pixels composing the first image;
a process of acquiring information of an average value and a standard deviation of second pixel values of a plurality of second pixels composing a second image captured in a state in which no electron beam is detected by the detector; and
a process of classifying the first image based on the average value and the standard deviation of the first pixel values and the average value and the standard deviation of the second pixel values.

According to a second aspect of the present disclosure, there is provided an image classification method in a transmission electron microscope including:

an illumination system that illuminates a specimen with an electron beam;
an imaging system that forms an image using the electron beam that has been transmitted through the specimen; and
a detector that captures the image formed by the imaging system,
the image classification method including:

a step of acquiring a first image captured by the detector;
a step of calculating an average value and a standard deviation of first pixel values of a plurality of first pixels composing the first image;
a step of acquiring information of an average value and a standard deviation of second pixel values of a plurality of second pixels composing a second image captured in a state in which no electron beam is detected by the detector; and
a step of classifying the first image based on the average value and the standard deviation of the first pixel values and the average value and the standard deviation of the second pixel values.

According to a third aspect of the present disclosure, there is provided an electron beam adjusting method including the above image classification method including:

a step of calculating a first positional deviation amount between a position of the electron beam on the first image and a center of the first image when the first image is classified as a beam image;

a step of including magnification information of the first image in first calibration data representing a relation between an amount of movement of a beam on an image and an amount of control of a deflector that deflects the electron beam;

a step of obtaining the amount of control of the deflector from the first positional deviation amount using the first calibration data including the magnification information of the first image; and

a step of calculating an error in a magnification ratio of the first image based on a position of the electron beam at the time when the deflector is caused to deflect the electron beam based on the obtained amount of control of the deflector to move the electron beam.

BRIEF DESCRIPTION OF THE DRAWINGS

FIG. 1 is a diagram illustrating one example of a configuration of a transmission electron microscope according to one embodiment of the invention.

FIG. 2 illustrates one example of a configuration of a control device.

FIG. 3 illustrates types of images.

FIG. 4 illustrates an image classification method.

FIG. 5 illustrates a coefficient of variation that becomes a judgment value.

FIG. 6 illustrates a result of detection of a beam.

FIG. 7 illustrates a method of obtaining an error in a magnification ratio.

FIG. 8 is a flowchart illustrating one example of a beam adjusting process by a control device.

FIG. 9 is a flowchart illustrating one example of a spotting process.

FIG. 10 is a flowchart illustrating one example of a beam centering process.

FIG. 11 illustrates a modified example of a judgment method using a coefficient of variation.

DESCRIPTION OF THE INVENTION

According to an embodiment of the present disclosure, there is provided a transmission electron microscope including:

an illumination system that illuminates a specimen with an electron beam;
an imaging system that forms an image using the electron beam that has been transmitted through the specimen;
a detector that captures the image formed by the imaging system; and
an arithmetic unit that classifies the image captured by the detector,
the arithmetic unit performing:

a process of acquiring a first image captured by the detector;
a process of calculating an average value and a standard deviation of first pixel values of a plurality of first pixels composing the first image;
a process of acquiring information of an average value and a standard deviation of second pixel values of a plurality of second pixels composing a second image captured in a state in which no electron beam is detected by the detector; and
a process of classifying the first image based on the average value and the standard deviation of the first pixel values and the average value and the standard deviation of the second pixel values.

Such a transmission electron microscope classifies first images based on an average value and a standard deviation of first pixel values of a plurality of first pixels configuring first images and an average value and a standard deviation of second pixel values of a plurality of second pixels configuring second images captured in a state in which no electron beam is detected by a detector. For this reason, such a transmission electron microscope can classify images without depending on users' experiences.

According to an embodiment of the present disclosure, there is provided an image classification method in a transmission electron microscope including:

an illumination system that illuminates a specimen with an electron beam;
an imaging system that forms an image using the electron beam that has been transmitted through the specimen; and
a detector that captures the image formed by the imaging system,
the image classification method including:

a step of acquiring a first image captured by the detector;
a step of calculating an average value and a standard deviation of first pixel values of a plurality of first pixels composing the first image;
a step of acquiring information of an average value and a standard deviation of second pixel values of a plurality of second pixels composing a second image captured in a state in which no electron beam is detected by the detector; and
a step of classifying the first image based on the average value and the standard deviation of the first pixel values and the average value and the standard deviation of the second pixel values.

In such an image classification method, first images are classified based on an average value and a standard deviation of first pixel values of a plurality of first pixels configuring first images and an average value and a standard deviation of second pixel values of a plurality of second pixels configuring second images captured in a state in which no electron beam is detected by a detector. For this reason, in such an image classification method, images can be classified without depending on users' experiences.

According to an embodiment of the present disclosure, there is provided an electron beam adjusting method including the above image classification method including:

a step of calculating a first positional deviation amount between a position of the electron beam on the first image and a center of the first image when the first image is classified as a beam image;
a step of including magnification information of the first image in first calibration data representing a relation between an amount of movement of a beam on an image and an amount of control of a deflector that deflects the electron beam;
a step of obtaining the amount of control of the deflector from the first positional deviation amount using the first calibration data including the magnification information of the first image; and
a step of calculating an error in a magnification ratio of the first image based on a position of the electron beam at the time when the deflector is caused to deflect the electron beam based on the obtained amount of control of the deflector to move the electron beam.

In such an electron beam adjusting method, the error in the magnification ratio can be calculated, and thus the electron beam can be accurately moved to the center of an image.

Now preferred embodiments of the invention will be described in detail with reference to the drawings. The embodiments described below are not intended to unduly limit the contents of the invention described in the claims. Further, all of the components described below are not necessarily essential requirements of the invention.

1. Transmission Electron Microscope

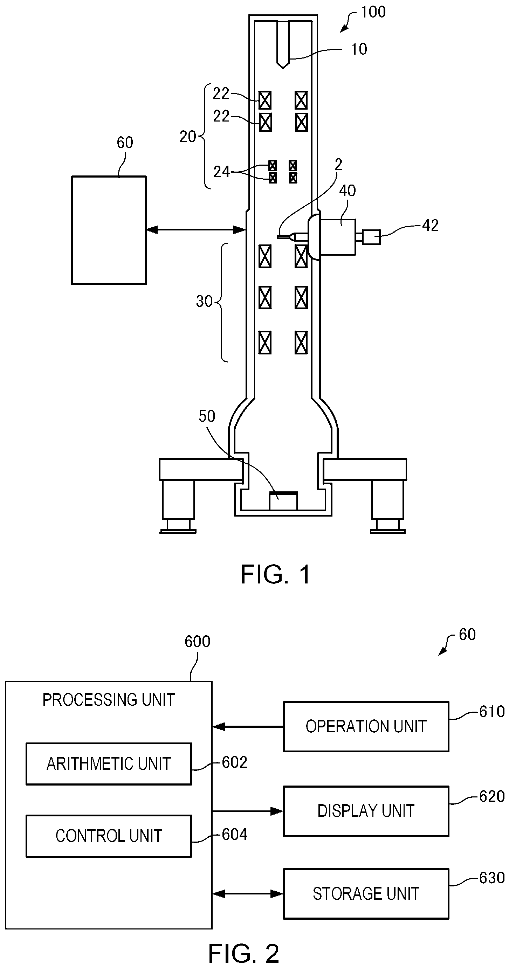

First, a transmission electron microscope according to one embodiment of the invention will be described with reference to the drawings. FIG. 1 is a diagram illustrating one example of the configuration of a transmission electron microscope 100 according to one embodiment of the invention.

The transmission electron microscope 100, as illustrated in FIG. 1, includes an electron gun 10, an illumination system 20, an imaging system 30, a specimen stage 40, a detector 50, and a control device 60.

The electron gun 10 discharges an electron beam (hereinafter, also simply referred to as a beam). The electron gun 10 accelerates electrons discharged from the cathode at the anode and discharges an electron beam.

The illumination system 20 illuminates a specimen 2 with the electron beam discharged from the electron gun 10. The illumination system 20 includes a plurality of condenser lenses 22 and a deflector 24. The condenser lenses 22 causes the electron beam to converge and illuminates the specimen 2 with the electron beam. The diameter of the electron beam can be controlled by the condenser lenses 22. The deflector 24 deflects the electron beam.

The imaging system 30 forms an image using an electron beam that has been transmitted through the specimen 2. The imaging system 30 includes an objective lens, an intermediate lens, and a projection lens. The objective lens forms a TEM image or a diffraction pattern. The intermediate lens enlarges an image formed by the objective lens. The projection lens further enlarges an image enlarged by the intermediate lens and forms a resultant image on the detector 50.

The specimen stage 40 positions a specimen 2 held in a specimen holder 42. In the example illustrated in the drawing, the specimen stage 40 is a side-entry stage into which a specimen 2 is inserted from the side of a pole piece of the objective lens.

The detector 50 captures an image formed by the imaging system 30. The detector 50, for example, is a digital camera such as a charge coupled device (CCD) camera, a complementary metal oxide semiconductor (CMOS) camera, or the like.

In the transmission electron microscope 100, an electron beam discharged from the electron gun 10 is caused to converge by the illumination system 20 and the specimen 2 is illuminated with the electron beam, an image is formed using an electron beam that has been transmitted through the specimen 2 by the imaging system 30, and the image is captured by the detector 50.

The control device 60 controls each part of the transmission electron microscope 100.

FIG. 2 is a diagram illustrating one example of the configuration of the control device 60. The control device 60, as illustrated in FIG. 2, includes a processing unit 600, an operation unit 610, a display unit 620, and a storage unit 630.

The operation unit 610 is used for a user to input operation information and outputs input operation information to the processing unit 600. The function of the operation unit 610 can be realized by an input device such as a keyboard, a mouse, a button, a touch panel, a touch pad, or the like.

The display unit 620 displays an image generated by the processing unit 600. The function of the display unit 620 can be realized by a liquid crystal display (LCD), a cathode ray tube (CRT), a touch panel functioning also as the operation unit 610, or the like. An image captured by the detector 50 is displayed in the display unit 620.

The storage unit 630 stores programs and various kinds of data used for causing a computer to function as each part of the processing unit 600. In addition, the storage unit 630 functions also as a work area of the processing unit 600. The function of the storage unit 630 can be realized using a hard disk, a random access memory (RAM), or the like.

The function of the processing unit 600 can be realized by executing a program using hardware such as one of various processors (a central processing unit (CPU) and the like). The processing unit 600 includes an arithmetic unit 602 and a control unit 604.

The arithmetic unit 602 performs processes such as a process of classifying an image acquired by the transmission electron microscope 100, a process of adjusting an optical system including the illumination system 20 and the imaging system 30, and the like. The control unit 604 controls each part of the transmission electron microscope 100. The control unit 604, for example, controls the optical system based on a calculation result acquired by the arithmetic unit 602. Details of the process by the control device 60 will be described below.

## 2. Electron Beam Adjusting Method

### 2.1. Beam Centering

The transmission electron microscope 100 performs beam centering as adjustment of an electron beam before observation of a TEM image. The beam centering represents that the illumination system 20 is adjusted such that the center of an electron beam is positioned at the center of an image captured by the detector 50. Hereinafter, a method of adjusting an electron beam will be described.

### 2.2. Image Classification Method

In order to perform beam centering, it is necessary to detect a beam having a circular shape that has been narrowed to an appropriate diameter. When a beam having a circular shape is not present on the screen of the display unit 620, it is necessary to perceive which image is being displayed on the screen. Thus, in order to perform beam centering, first, the transmission electron microscope 100 classifies initial images captured in the optical system of the current state.

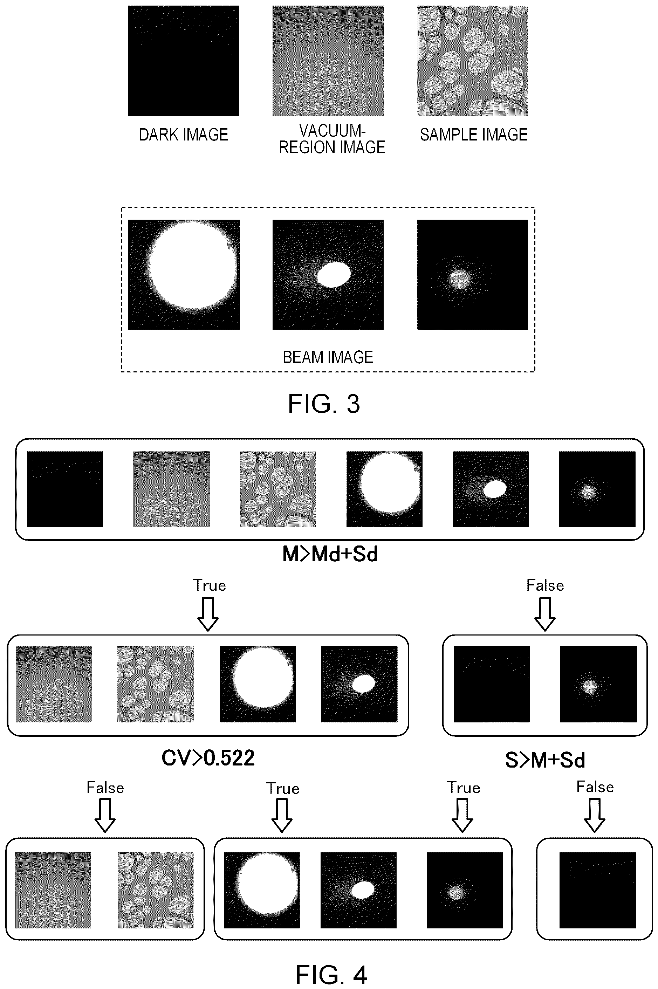

FIG. 3 illustrates kinds of images. Images observed by the transmission electron microscope 100 can be roughly classified into four kinds. More specifically, images observed by the transmission electron microscope 100 can be classified into four kinds of a dark image, a vacuum region image, a sample image (specimen image), and a beam image.

The dark image is an image captured in a state in which no electron beam is detected by the detector 50. The dark image is an image captured by the detector 50, for example, when the electron beam deviates from the detector 50, a case in which the electron beam does not arrive at the detector 50, a case in which the electron beam is too widened and is in a level lower than a level that can be detected by the detector 50, or the like.

The beam image is an image that includes all the contours of the electron beam in an image. The vacuum region image is an image that is captured by the detector 50 by illuminating a vacuum region other than a specimen with an electron beam. The sample image is an image that is acquired by illuminating a specimen 2 with an electron beam and capturing a specimen image formed by electrons that have been transmitted through the specimen 2 using the detector 50.

In addition, an image captured by the detector 50, for example, is configured using 1856 × 1856 pixels. A pixel value (a luminance value) of one pixel, for example, has 8 bits, that is, a value of 0 to 256 (256 grayscale values). A pixel value of a pixel represents shading, represents black when the pixel value is zero, and represents white when the pixel value is 255. In other words, an image captured by the detector 50 is a grayscale image.

FIG. 4 illustrates an image classification method. In this embodiment initial images are classified based on an average value M and a standard deviation S of pixel values of a plurality of images configuring the initial images, an average value Md of pixel values of a plurality of pixels configuring a dark image, and a standard deviation Sd of the pixel values of the plurality of pixels configuring the dark image.

First, an image is classified by setting a sum Md + Sd of the average value Md and the standard deviation Sd of the dark image as a judgment value and judging whether or not the average value M of initial images is larger than this judgment value. The reason for the inclusion of the standard deviation Sd in the judgment criterion is for taking the effect of noise according to the detector 50 into account.

Here, images are divided into images for which the average value M of initial images is larger than the judgment value Md + Sd (hereinafter, also referred to as bright images) and images for which the average value M is the judgment value Md + Sd or less (hereinafter, also referred to as dark images). Images satisfying M > Md + Sd, that is, bright images include a vacuum region image, a sample image, and a bright beam image. Images not satisfying M > Md + Sd, that is, dark images include a dark image and a dark beam image.

Next, for an initial image that has been judged not to satisfy M > Md + Sd, it is judged whether or not the initial image is a dark image. The judging of whether or not an initial image is a dark image is performed based on whether or not the standard deviation S of pixel values of initial images is larger than a sum M + Sd of the average value M of the pixel values of the initial images and the standard deviation Sd of pixel values of dark images.

Here, while most of pixel values of an image area that is not hit by an electron beam are values close to zero, an image area of a focused beam has large pixel values. For this reason, the value of the standard deviation of a beam image is higher than that of a dark image. Thus, when "S > M + Sd" is satisfied, the corresponding image can be classified as a beam image. In addition, when "S > M + Sd" is not satisfied, the corresponding image can be classified as a dark image.

Next, it is judged whether or not an initial image that has been judged to satisfy "M > Md + Sd" is a beam image. The judging of whether or not an initial image is a beam image is performed based on a coefficient of variation CV of the initial image. Here, whether or not an initial image is a beam image is judged by comparing a coefficient of variation CV of pixel values of an initial image with a coefficient of variation CVb of pixel values of a plurality of pixels composing an image that includes all the contours of the electron beam inside the image and has a maximum diameter of the electron beam.

Here, the coefficient of variation is a value acquired by dividing the standard deviation by the average value. When the coefficient of variation is high, it represents high irregularity from the average value when the entire data is seen, and, when the coefficient of variation is low, it represents a small deviation from the average value. Thus, in a beam image in which black and white are clearly separated, the coefficient of variation tends to be high.

The coefficient of variation CVb of pixel values of a plurality of pixels composing an image that includes all the contours of the electron beam inside the image serving as a judgment value and has a maximum diameter of the electron beam can be obtained as below.

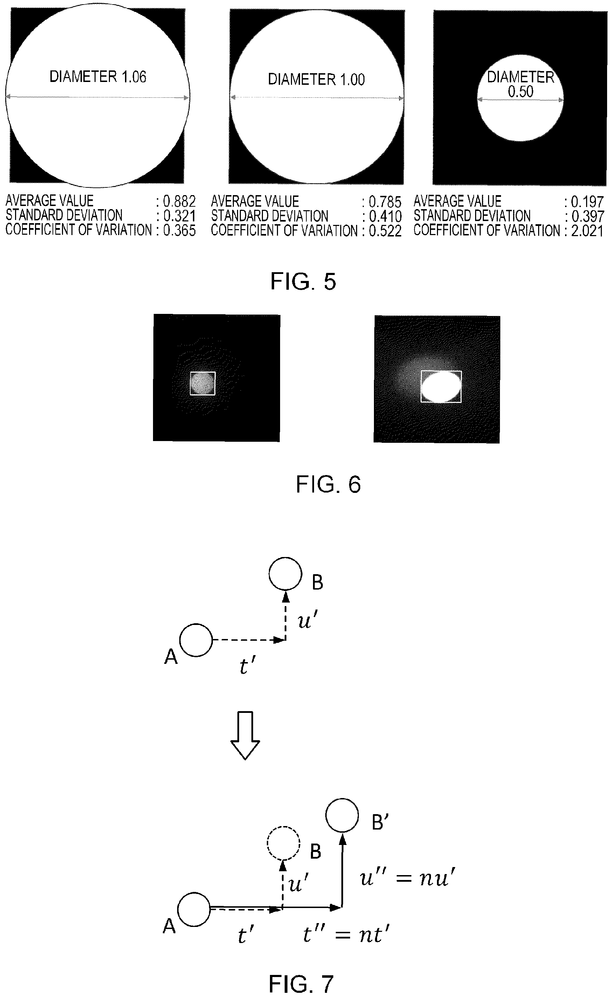

FIG. 5 illustrates a coefficient of variation CVb that becomes a judgment value for judging whether or not a corresponding image is a beam image from a coefficient of variation CV.

FIG. 5 illustrates three circles, of which diameters are different from each other, drawn on squares. The diameters of the circles are represented as 1.06, 1.00, and 0.50 by setting one side of the square as 1. The center of the circle and the center of the square coincide with each other. At this time, each average value, each standard deviation, and each coefficient of variation are obtained by using "1" as the pixel value of a circle part and "0" as the pixel value of a square part. As illustrated in FIG. 5, the smaller the radius of the circle, the higher the coefficient of variation. Thus, it can be understood that the more the beam is focused, the higher the coefficient of variation becomes.

Here, in consideration of a case in which the diameter of the beam becomes a maximum among images captured by the detector 50, the judgment value is set to 0.522 that is a coefficient of variation of a case in which the diameter of the circle becomes the same as the length of one side of the square. In other words, the coefficient of variation CVb of pixels values of a plurality of pixels composing an image that includes all the contours of the electron beam inside the image and has a maximum diameter of the electron beam is set as the judgment value. Thus, when the coefficient of variation CV of pixel values of an initial image is larger than the coefficient of variation CVb (= 0.522), in other words, when "CV > CVb" is satisfied, the initial image can be classified as a beam image. In addition, when the coefficient of variation CV is not larger than the coefficient of variation CVb, in other words, when "CV > CVb" is not satisfied, the initial image can be classified as a vacuum region image or a sample image.

In this way, initial images can be classified.

2.3. Shape Detection

Next, a shape detection algorithm is applied to initial images classified as beam images. In shape detection, binarization of a beam image, contour extraction, and detection of a maximum-area rectangle inside the image are performed. As a technique for binarization of a beam image, for example, a known binarization technique such as Otsu's binarization or the like can be used. By binarizing a beam image, extraction of the contour of a beam can be easily performed. The contour of a beam is extracted from a binarized beam image by performing known image processing, and a maximum-area rectangle enclosing the extracted beam is detected.

FIG. 6 illustrates a result of detection of a beam. As illustrated in FIG. 6, by applying a shape detection algorithm to a beam image, the beam can be detected. As illustrated in FIG. 6, a quadrilateral enclosing a beam is a rectangle having two sides that are parallel to a vertical direction of an image and two sides that are parallel to a horizontal direction of the image. By detecting such a quadrilateral, a size of the beam in the vertical direction of the image and a size of the beam in the horizontal direction of the image can be measured.

Here, in this embodiment, by applying the shape detection algorithm only to initial images classified as beam images, a beam is detected. For example, when the shape detection algorithm is applied to a dark image, a vacuum region image, or a sample image, it takes time to extract the contour, and thus it takes a considerable time for a shape detecting process. In this embodiment, since the shape detection algorithm is applied only to initial images classified as beam images, although the process of classifying images is performed, the processing time can be shortened.

2.4. Beam Spotting

(1) Beam Image

Next, a process of spotting a beam is performed for an initial image classified as a beam image. The spotting of a beam represents converting the beam into a spot shape of a size with the radius of the beam determined.

Here, it is judged that a beam is formed to have a spot shape when the size of the beam in the vertical direction of an image and the size of the beam in the horizontal direction of the image at the lowest magnification enter a range represented below.

horizontal width of image $\times$ 0.2/2 $\leq$ horizontal width of beam/2 $\leq$ horizontal width of image $\times$ 0.5/2

vertical width of image $\times$ 0.2/2 $\leq$ vertical width of beam/2 $\leq$ horizontal width of image $\times$ 0.5/2

In addition, the values described above are examples, and judgment criteria of the size of a beam for judging whether or not the beam is formed to have a spot shape may be set to arbitrary values as long as they are in the range of the size of the beam for which a beam centering process to be described below can be easily performed.

In a beam image, a horizontal width of a beam and a vertical width of the beam are measured from a maximum-area quadrilateral enclosing the beam detected through the shape detection described above, and it is judged whether or not the beam is formed to have a spot shape. When the shape of a beam detected in a beam image does not have a spot shape, the excitation value of the condenser lens 22 is gradually decreased from a maximum value until the shape of the beam enters the range described above. In accordance with this, the beam can be formed in a spot shape. By spotting a beam, an initial image can be formed as a spot image including a beam having a spot shape.

In addition, a calibration value of the excitation value of the condenser lens 22 for which the shape of the beam enters the range described above is obtained in advance, and the excitation value of the condenser lens 22 may be set to this calibration value. In accordance with this, an initial image can be converted into a spot image.

(2) Dark Image

When an initial image is a dark image, three situations including a case in which the value of the deflector 24 is inappropriate, and the beam is beyond a range in which the beam is imaged by the detector 50, a case in which an electron beam reaches up to the detector 50, and the beam is too widened, and a case in which the beam does not reach up to the detector 50 are considered.

For this reason, first, the transmission electron microscope 100 is set to a lowest magnification. When the beam is not formed to have a spot shape even with the lowest magnification, the excitation value (a control value) of the deflector 24 is set to a neutral value in the state of the lowest magnification. The neutral value, for example, is a value not causing the deflector 24 to deflect an electron beam. When the beam is not formed to have a spot shape even in this case, in a state in which the magnification is the lowest magnification, and the excitation value of the deflector 24 is the neutral value, the excitation value of the condenser lens 22 for controlling the beam diameter is gradually decreased from a maximum value. In addition, the excitation value of the condenser lens 22 may be set to a calibration value for forming the shape of a beam into a spot shape. When the beam is not formed to have a spot shape also in this case, a case in which the beam does not reach up to the detector 50 is considered. When the beam does not reach up to the detector 50, the beam cannot be formed in a spot shape, and thus the process ends.

In this way, also when an initial image is a dark image, the beam can be formed to have a spot shape, and thus a spot image can be acquired.

(3) Sample Image or Vacuum Region Image

Also when an initial image is a sample image or a vacuum region image, a beam can be formed to have a spot shape using a technique similar to that of the case of the dark image described above, and thus a spot image can be acquired.

(4) Adjustment And Magnification Correction of Condenser Lens

After checking that the beam is formed to have a spot shape, the excitation value of the condenser lens 22 may be adjusted such that the focus of the beam is positioned on the over-side. Judging whether or not the focus of the beam is present on the over-side can be performed based on whether or not the beam diameter increases when the excitation value of the condenser lens 22 is increased. When the beam diameter increases when the excitation value of the condenser lens 22 is increased, the focus of the beam is positioned on the over-side.

In addition, when the magnification is the lowest magnification when the beam is formed to have a spot shape, the excitation value of the condenser lens 22 is controlled such that the beam is formed to have a spot shape with the magnification of an initial image. In accordance with this, a spot image having the same magnification as that of the initial image can be acquired.

2.5. Beam Centering

The beam centering is a process of moving the center of gravity of the luminance of a beam to the center of an image captured by the detector 50. In order to move the beam to the center of an image captured by the detector 50, the deflector 24 of the illumination system 20 is used. Here, the deflector 24 has an X coil deflecting a beam in the X direction and a Y coil deflecting a beam in the Y direction. An equation of the amount of movement representing by which pixels the beam moves on an image when the X coil is changed by one bit is represented using the following equation.

$$t = a\Delta x + b\Delta y$$

$$u = c\Delta x + d\Delta y$$

Here, t is the amount of movement (pixels) of the beam on an image in the X direction, and u is the amount of movement (pixels) of the beam on the image in the Y direction. In addition, $\Delta x$ is the amount of displacement (bits) of the excitation value of the X coil, and $\Delta y$ is the amount of displacement (bits) of the excitation value of the Y coil. In addition, a, b, c, and d are constants (pixels/bit).

The constants a, b, c, and d, for example, can be acquired by obtaining the amount of shift of the beam per bit from the amounts of shift of the beam before and after change when the X coil and the Y coil are changed by a predetermined number of bits.

In addition, in the equation described above, magnification information at the time of acquiring the constants a, b, c, and d is included. In the magnification information, information of a magnification ratio and information of a rotation angle are included. In the transmission electron microscope 100, since an electron lens is used, when the magnification ratio is changed, the image is rotated in accordance with the change in the magnification ratio. Thus, in the transmission electron microscope 100, the rotation angle of the image is different for each magnification. For this reason, in the magnification information, the information of a magnification ratio and the information of a rotation angle of the image are included.

A relation (calibration data) between the amount of movement of the beam except for the magnification information and the amount of displacement (the amount of control) of the excitation value of the deflector 24 can be represented in the following Equation (1).

$$\begin{pmatrix} t_0 \\ u_0 \end{pmatrix} = \frac{1}{m} \begin{pmatrix} \cos\theta & -\sin\theta \\ \sin\theta & \cos\theta \end{pmatrix}^{-1} \begin{pmatrix} a & b \\ c & d \end{pmatrix} \begin{pmatrix} \Delta x \\ \Delta y \end{pmatrix} \cdots (1)$$

In addition, $t_0$ is the amount of movement (pixels) of the beam on the image in the X direction except for the magnification information, and $u_0$ is the amount of movement (pixels) of the beam on the image in the Y direction except for the magnification information. m is a magnification ratio at the time of calibration, and $\theta$ is a degree of a rotation angle at the time of calibration.

Here, calibration data represented in Equation (1) described above requires information of a magnification ratio at the time of calibration as the coefficient m and requires information of a rotation angle at the time of calibration as the coefficient $\theta$. As the magnification ratio at the time of calibration, a display magnification displayed in the display unit 620 is used. The display magnification is a magnification ratio set in the transmission electron microscope 100 in advance and is a magnification ratio that is referred to when a user changes the magnification. The rotation angle at the time of calibration can be calculated from the excitation value of the lens of the imaging system 30.

Here, although the display magnification is used as the magnification ratio m at the time of calibration, error is included in the display magnification. For this reason, when the display magnification at the time of calibration and the display magnification of an initial image are different from each other, beam centering cannot be accurately performed. In addition, even when the magnification at the time of calibration and the magnification of the initial image are the same, an error occurs in the magnification ratio due to deviation of a focus position and the influence of hysteresis of the lens of the imaging system. Also in this case, beam centering cannot be accurately performed.

Thus, in this embodiment, by obtaining an error in the magnification ratio of the initial image using the magnification ratio at the time of calibration as a reference, the accuracy of the beam centering is improved.

FIG. 7 illustrates a method of acquiring an error in a magnification ratio. A position A is an initial position on an image, and a position B is a position of the center of the image.

Before an error in the magnification ratio of the initial image is acquired, the amount of movement of the beam in a state in which there is no error in the magnification ratio is calculated. For a certain magnification ratio m', an amount of displacement $\Delta x'$ of the excitation value of the X coil and the amount of displacement $\Delta y'$ of the excitation value of the Y coil at the time of moving the beam by the amount of movement (t', u') can be represented in the following Equation (2).

$$\begin{pmatrix} t' \\ u' \end{pmatrix} = m' \begin{pmatrix} \cos\theta' & -\sin\theta' \\ \sin\theta' & \cos\theta' \end{pmatrix} \begin{pmatrix} t_0 \\ u_0 \end{pmatrix}$$

$$= \frac{m'}{m} \begin{pmatrix} \cos\theta' & -\sin\theta' \\ \sin\theta' & \cos\theta' \end{pmatrix} \begin{pmatrix} \cos\theta & -\sin\theta \\ \sin\theta & \cos\theta \end{pmatrix}^{-1} \begin{pmatrix} a & b \\ c & d \end{pmatrix} \begin{pmatrix} \Delta x' \\ \Delta y' \end{pmatrix}$$

$$\cdots (2)$$

In addition, $\theta'$ is a degree pf a rotation angle at the magnification ratio m'.

By using Equation (2) as calibration data representing a relation between the amount of movement of the beam on an image and the amount of excitation of the deflector 24, on the screen of the display magnification m', the amount of displacement $\Delta x'$ of the excitation value of the X coil and the amount of displacement $\Delta y'$ of the excitation value of the Y coil for moving the beam from the initial position A to the position B that is the center of the image are obtained. Then, the excitation value of the X coil is changed by the amount of displacement $\Delta x'$, and the excitation value of the Y coil is changed by the amount of displacement $\Delta y'$. In accordance with this, ideally, as illustrated in FIG. 7, the beam is moved from the initial position A by the amount of movement t' in the X direction and the amount of movement u' in the Y direction, and the beam reaches the position B.

However, when there is an error in the display magnification m', an actual amount of movement at the time of changing the excitation value of the X coil by the amount of displacement $\Delta x'$ and changing the excitation value of the Y coil by an amount of displacement $\Delta y'$ becomes an amount of movement t" = nt' in the X direction and an amount of movement u" = nu' in the Y direction. Thus, an actual magnification becomes n times the display magnification m'. As a result, the error in the magnification ratio can be represented in the following Equation (3).

$$n = \frac{t''}{t'} = \frac{u''}{u'} \quad \cdots (3)$$

Here, n is a coefficient of the error in the magnification ratio.

Thus, a relation (calibration data) between the amount of movement of the beam and the amount of displacement of the excitation value of the deflector 24 in consideration of the error in the magnification ratio can be represented in the following Equation (4).

$$\begin{pmatrix} t' \\ u' \end{pmatrix} = \frac{m'}{n} \begin{pmatrix} \cos\theta' & -\sin\theta' \\ \sin\theta' & \cos\theta' \end{pmatrix} \begin{pmatrix} t_0 \\ u_0 \end{pmatrix}$$

$$= \frac{m'}{mn} \begin{pmatrix} \cos\theta' & -\sin\theta' \\ \sin\theta' & \cos\theta' \end{pmatrix} \begin{pmatrix} \cos\theta & -\sin\theta \\ \sin\theta & \cos\theta \end{pmatrix}^{-1} \begin{pmatrix} a & b \\ c & d \end{pmatrix} \begin{pmatrix} \Delta x' \\ \Delta y' \end{pmatrix}$$

$$\cdots (4)$$

By using Equation (4) described above, again, the amount of displacement Δx' of the excitation value of the X coil and the amount of displacement Δy' of the excitation value of the Y coil for moving the beam from the initial position A to the position B that is the center of the image are obtained. In accordance with this, the beam is moved from the initial position A by an amount of movement t' in the X direction and an amount of movement u' in the Y direction, and the beam reaches the position B.

In addition, in the description presented above, although the beam is moved from the initial position A to the position B using Equation (4), the beam may be moved from a position B' to the position B using Equation (4).

In this way, in this embodiment, first, in an image with the display magnification m', the amount of excitation of the deflector 24 is calculated using Equation (2), and the beam is moved. Next, an error in the magnification ratio m' represented in Equation (3) is obtained from a deviation between the position B' of the beam after movement and the position B. Finally, the amount of excitation of the deflector 24 is calculated using Equation (4) in which the error in the magnification ratio is considered, and the beam is moved to the position B. Thus, even when the beam deviates from the center of the image in accordance with first-time movement of the beam, in accordance with the second movement, the beam can be moved to the center of the image.

When the coefficient n of the error in the magnification ratio of the display magnification m' represented in Equation (3) is obtained once, when beam centering is performed with the display magnification m' next, it can be used. Thus, by obtaining an error in the magnification ratio for each display magnification, for each display magnification, error information for the magnification ratio is stored in the storage unit 630, and thus the beam can be accurately moved to the center of the image also for any display magnification through one-time movement of the beam.

3. Beam Adjusting Process

3.1. Image Classification Process

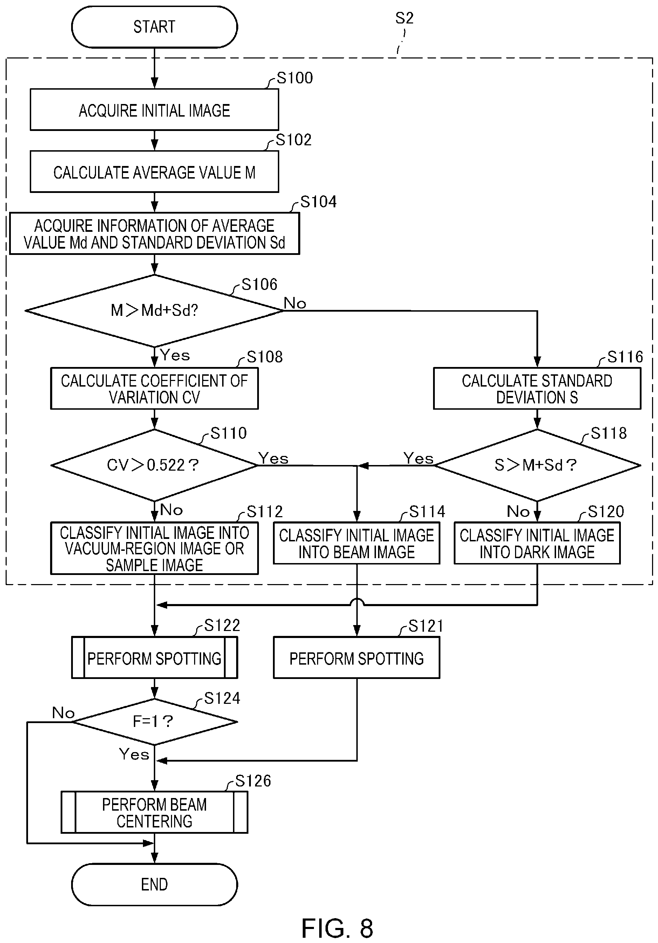

FIG. 8 is a flowchart illustrating one example of a beam adjusting process by the control device 60.

First, the arithmetic unit 602 classifies initial images (Step S2). More specifically, first, the arithmetic unit 602 acquires an initial image (Step S100). The initial image is an image captured by the transmission electron microscope 100 and is automatically captured using the control unit 604. The initial image captured by the detector 50 is transmitted to the arithmetic unit 602.

Next, the arithmetic unit 602 calculates an average value M of pixel values of pixels composing the initial image (Step S102). When the initial image is composed of 1856 × 1856 pixels, the arithmetic unit 602 calculates an average value M of pixel values of the 1856 × 1856 pixels.

Next, the arithmetic unit 602 acquires information of an average value Md and a standard deviation Sd of pixel values of pixels composing a dark image (Step S104). The information of the average value Md and the standard deviation Sd is stored in the storage unit 630 in advance. Imaging is performed in a state in which no electron beam is detected by the detector 50, and the average value Md and the standard deviation Sd can be calculated from the acquired dark image.

Next, the arithmetic unit 602 judges whether or not "M > Md + Sd" is satisfied (Step S106). When it is judged that "M > Md + Sd" is satisfied (Yes in Step S106), the arithmetic unit 602 calculates a coefficient of variation CV of pixel values of pixels composing an initial image (Step S108). In addition, in Step S102, the arithmetic unit 602 may calculate an average value M, a standard deviation S, and a coefficient of variation CV.

Next, the arithmetic unit 602 judges whether or not the coefficient of variation CV satisfies "CV > 0.522" (Step S110). When it is judged that "CV > 0.522" is satisfied (Yes in Step S110), the arithmetic unit 602 classifies the initial image into a beam image (Step S114). On the other hand, when it is judged that "CV > 0.522" is not satisfied (No in Step S110), the arithmetic unit 602 classifies the initial image into a vacuum region image or a sample image (Step S112).

When it is judged that "M > Md + Sd" is not satisfied (No in Step S106), the arithmetic unit 602 calculates a standard deviation S of the pixel values of the pixels composing the initial image (Step S116). Next, the arithmetic unit 602 judges whether or not "S > M + Sd" is satisfied (Step S118). When it is judged that "S > M + Sd" is satisfied (Yes in Step S118), the arithmetic unit 602 classifies the initial image into a beam image (Step S114). When it is judged that "S > M + Sd" is not satisfied (No in Step S118), the arithmetic unit 602 classifies the initial image into a dark image (Step S120).

In accordance with the image classification process S2 of Step S100 to Step S120 described above, the initial image can be classified as any one of a vacuum region image or a sample image, a beam image, and a dark image.

After classifying the initial image into a beam image (after Step S114), the arithmetic unit 602 converts the beam into spots (Step S121). By detecting a beam by applying a shape detection algorithm to an initial image classified as a beam image, the arithmetic unit 602 judges whether or not the beam has a spot shape. When the arithmetic unit 602 judges that the beam is not formed to have a spot shape, the control unit 604 gradually decreases the excitation value of the condenser lens 22 from a maximum value and converts the beam into a spot shape. In accordance with this, a spot image can be acquired.

After classifying an initial image into a vacuum region image or a sample image (after Step S112) or after classifying an initial image into a dark image (after Step S120), the arithmetic unit 602 converts the electron beam into spots (Step S122). The spotting process in Step S122 will be described below. In the spotting process in Step S122, as will be described below, a flag F indicating success/failure of spotting is set to F = 1 when the electron beam has been able to be converted into spots, and the flag F is set to F = 0 when the electron beam has not been able to be converted into spots.

When the electron beam is converted into spots, and F = 1 is set (Yes in Step S124), or after the beam is converted into spots in the initial image classified as a beam image (after Step S121), the arithmetic unit 602 performs a beam centering process (Step S126). The beam centering process will be described below.

After the beam centering process ends (after Step S126) or when the electron beam has not been able to be converted into spots, and F = 0 is set (No in Step S124), the arithmetic unit 602 ends the beam adjusting process.

3.2. Spotting Process

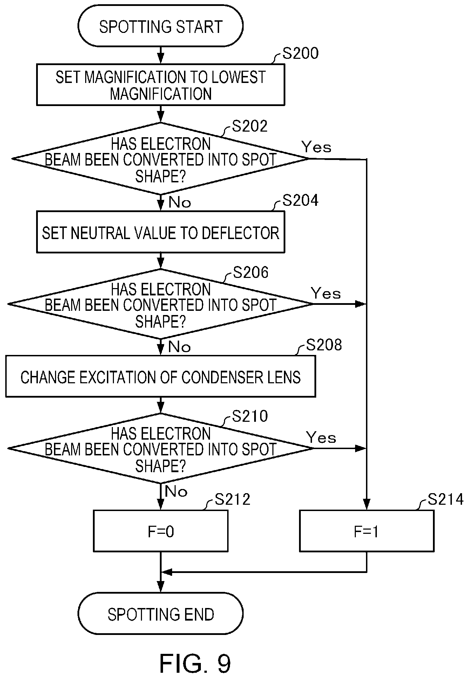

FIG. 9 is a flowchart illustrating one example of a spotting process.

When the arithmetic unit 602 classifies an initial image into a vacuum region image or a sample image in the process in Step S112 illustrated in FIG. 8 or when the initial image is classified as a dark image in the process in Step S120, the control unit 604 executes the spotting process. More specifically, the control unit 604, first, sets an observation magnification to a lowest magnification (Step S200). Next, the control unit 604 judges whether or not the electron beam has been formed to have a spot shape (Step S202). For example, for the lowest magnification, when the size of the beam in the vertical direction of the image and the size of the beam in the horizontal direction of the image enter a range represented below, the control unit 604 judges that the beam has been formed to have a spot shape.

horizontal width of image $\times$ 0.2/2 $\leq$ horizontal width of beam/2 $\leq$ horizontal width of image $\times$ 0.5/2

vertical width of image $\times$ 0.2/2 $\leq$ vertical width of beam/2 $\leq$ horizontal width of image $\times$ 0.5/2

When it is judged that the electron beam has not been formed to have a spot shape (No in Step S202), the control unit 604 sets the excitation value of the deflector 24 to a neutral value in the state in which the magnification is the lowest magnification (Step S204). Then, the control unit 604 judges whether or not the electron beam has been formed to have a spot shape (Step S206).

When it is judged that the electron beam has not been formed to have a spot shape (No in Step S206), in a state in which the magnification is set to the lowest magnification and in a state in which the excitation value of the deflector 24 is set to the neutral value, the control unit 604 gradually changes the excitation value of the condenser lens 22 used for controlling the beam diameter from a maximum value (Step S208). In addition, in the process in Step S208, the excitation value of the condenser lens 22 may be set to a calibration value used for converting the shape of the beam into a spot shape.

When it is judged that the electron beam has not been formed to have a spot shape (No in Step S210), the control unit 604 sets the flag F indicating success/failure of spotting to F = 0 representing that the beam has not been formed to have a spot shape (Step S212).

When it is judged that the spot shape has been formed (Yes in Step S202, Yes in Step S206, and Yes in Step S210), the control unit 604 sets the flag F to F = 1 representing that the beam has been formed to have a spot shape (Step S214).

After setting the flag F, the control unit 604 ends the spotting process. In this way, in accordance with the spotting process illustrated in FIG. 9, a spot image can be acquired from an initial image classified as a vacuum region image, a sample image, or a dark image.

3.3. Beam Centering Process

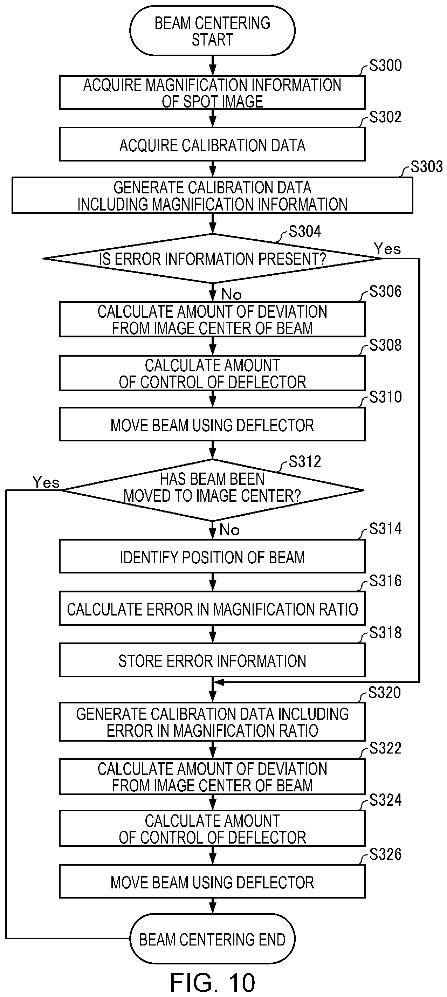

FIG. 10 is a flowchart illustrating one example of the beam centering process.

The beam centering process is performed for a spot image including an image of a beam having a spot shape. First, the arithmetic unit 602 acquires magnification information of the spot image. The magnification information of the spot image includes information of a magnification ratio m' and information of a rotation angle $\theta$' of the image. As the magnification ratio m', a display magnification is used.

Next, the arithmetic unit 602 acquires first calibration data (Step S302). The first calibration data can be represented in Equation (1). The first calibration data represented in Equation (1) does not include magnification information. The first calibration data is stored in the storage unit 630.

Next, the arithmetic unit 602 includes the magnification information of the spot image in the first calibration data to generate second calibration data (Step S303). The second calibration data can be represented in Equation (2).

Next, the arithmetic unit 602 judges whether or not error information for the magnification ratio acquired with the same magnification ratio as that of the spot image is stored in the storage unit 630 (Step S304). As will be described below, when error information for the magnification ratio for the magnification ratio m' has been previously generated, the error information for the magnification ratio m' is stored in the storage unit 630. When the error information for the magnification ratio m' is stored in the storage unit 630, the process for generating error information for the magnification ratio m' of Step S306 to Step S318 may not be performed.

When it is judged that error information for the magnification ratio m' is not present (No in Step S304), the arithmetic unit 602 calculates an amount of positional deviation between the position of the beam on the spot image and the center of the spot image (a first positional deviation amount) (Step S306). The first positional deviation amount includes an amount of positional deviation in the X direction and the amount of positional deviation in the Y direction.

Next, by using the first calibration data including the magnification information of the spot image, the arithmetic unit 602 acquires an amount of control of the deflector 24 from the first positional deviation amount acquired in Step S304, that is, the amount of displacement of the excitation value of the X coil, and the amount of displacement of the excitation value of the Y coil (Step S308). Since the first positional deviation amount corresponds to an amount of movement (t', u'), by using the first calibration data including the magnification information of the spot image represented in Equation (2), the amount of displacement $\Delta x$' of the excitation value of the X coil and the amount of displacement $\Delta y$' of the excitation value of the Y coil can be obtained.

The control unit 604 causes the deflector 24 to deflect the beam based on the amount of control of the deflector 24 acquired by the arithmetic unit 602 and moves the beam on the spot image (Step S310). The control unit 604 captures an image after movement of the beam.

The arithmetic unit 602 judges whether or not the beam has been moved to the center of the image (Step S312). When it is judged that the beam has not been moved to the center of the image (No in Step S312), the arithmetic unit 602 identifies the position of the beam after movement on the image (Step S314). The arithmetic unit 602 acquires the error n of the magnification ratio m' represented in Equation (3) from the position of the beam after movement (Step S316). The arithmetic unit 602 stores the acquired error information for the magnification ratio m' in the storage unit 630 (Step S318).

After the error information for the magnification ratio m' is calculated (after Step S318) or when the error information for the magnification ratio m' is stored in the storage unit 630 (Yes in Step S304), the arithmetic unit 602 generates second calibration data including the error information for the magnification ratio represented in Equation (4) (Step S320).

The arithmetic unit 602 calculates an amount of positional deviation between the position of the beam after movement and the center of the image (a second positional deviation amount) (Step S322). By using the second calibration data including the error information for the magnification ratio m', the arithmetic unit 602 obtains the amount of control of the deflector 24 from the second positional deviation amount acquired in Step S322 (Step S324). Since the amount of the second positional deviation corresponds to the amount of movement (t', u'), by using the second calibration data represented in Equation (4), the amount of displacement $\Delta x$' of the excitation value of the X coil and the amount of displacement $\Delta y$' of the excitation value of the Y coil can be obtained.

The control unit 604 causes the deflector 24 to deflect the beam based on the amount of control of the deflector 24 obtained by the arithmetic unit 602 to move the beam (Step S326).

After the control unit 604 causes the deflector 24 to move the beam (after Step S326) or when the arithmetic unit 602 judges that the beam has been moved to the center of the image (Yes in Step S312), the control device 60 ends the beam centering process.

In addition, by performing the beam centering process described above for each magnification, for each magnification, the error information for the magnification is stored in the storage unit 630. Thus, for the magnification of which the error information for the magnification is stored in the storage unit 630, the processes of Step S306 to Step S318 may not be performed, and thus the beam centering process can be efficiently performed.

4. Effects

The transmission electron microscope 100 includes an illumination system 20 used for illuminating a specimen 2 with an electron beam, an imaging system 30 forming an image using the electron beam that has been transmitted through the specimen 2, a detector 50 used for capturing the image formed by the imaging system 30, and an arithmetic unit 602 classifying images captured by the detector 50. In addition, the arithmetic unit 602 performs a process of acquiring an initial image (a first image) captured by the detector 50, a process of calculating an average value M and a standard deviation S of first pixel values of a plurality of first pixels composing the initial image, a process of acquiring information of an average value Md and a standard deviation Sd of second pixel values of a plurality of second pixels composing a dark image (a second image) captured in a state in which no electron beam is detected by the detector 50, and a process of classifying an image based on the average value M, the standard deviation S, the average value Md, and the standard deviation Sd.

For this reason, the transmission electron microscope 100 can classify the initial image without depending on user's experiences. Thus, in the transmission electron microscope 100, for example, when a beam centering process is automatically performed, a user may not display a beam image in advance. In addition, since the transmission electron microscope 100 classifies images based on the average value M, the standard deviation S, the average value Md, and the standard deviation Sd, the images can be classified without using image processing such as a shape detection algorithm or the like. Accordingly, the processing time can be shortened.

In the transmission electron microscope 100, the arithmetic unit 602, in the process of classifying an initial image, when it is judged that the average value M of the pixel values of the initial image is larger than a sum of the average value Md and the standard deviation Sd of the pixel values of the dark image, performs a process of judging whether or not the initial image is a beam image based on a coefficient of variation CV of the pixel values of the initial image. For this reason, the transmission electron microscope 100 can judge whether or not the initial image is a beam image.

In the transmission electron microscope 100, in the process of judging whether or not the initial image is a beam image, the arithmetic unit 602 judges whether or not the initial image is a beam image by comparing a coefficient of variation CV of the pixel values of the initial image with a judgment value based on a coefficient of variation CVb of pixel values of a plurality of pixels composing an image which includes all the contours of the electron beam inside the image and in which a diameter of the electron beam becomes a maximum. For this reason, the transmission electron microscope 100 can judge whether or not the initial image is a beam image.

In the transmission electron microscope 100, in the process of judging whether or not the initial image is a beam image, the arithmetic unit 602 classifies the initial image into a beam image when it is judged that a coefficient of variation CV of the pixel values of the initial image is larger than the judgment value. For this reason, the transmission electron microscope 100 can judge whether or not the initial image is a beam image.

The transmission electron microscope 100 includes a storage unit 630 and a control unit 604 controlling the illumination system 20, and the illumination system 20 includes a deflector 24 that deflects the electron beam. In addition, first calibration data representing a relation between an amount of movement of the beam on an image and an amount of control of the deflector 24 is stored in the storage unit 630. Furthermore, the arithmetic unit 602 performs a process of calculating a first positional deviation amount between a position of the electron beam on the initial image and a center of the initial image when the initial image is classified as a beam image, a process of including magnification information of the initial image in the first calibration data, a process of obtaining an amount of control of the deflector 24 from the first positional deviation amount using the first calibration data including the magnification information of the initial image, a process of calculating an error in a magnification ratio of the initial image based on a position of the electron beam at the time of moving the electron beam by causing the deflector 24 to deflect the electron beam based on the amount of control of the deflector 24 using the control unit 604, and a process of storing information of the calculated error in the magnification ratio in the storage unit 630. For this reason, the transmission electron microscope 100 can obtain the information of the error in the magnification ratio and thus can accurately move the beam.

In the transmission electron microscope 100, the arithmetic unit 602 performs a process of generating second calibration data by including the information of the error in the first calibration data including magnification information of the initial image, a process of calculating a second positional deviation amount between a position of the electron beam and a center of the initial image, and a process of obtaining an amount of control of the deflector 24 from the second positional deviation amount using the second calibration data, and the control unit 604 performs a process of causing the deflector 24 to deflect the electron beam based on the amount of control of the deflector 24. For this reason, the transmission electron microscope 100 can accurately move the beam to the center of the image.

In the transmission electron microscope 100, the information of the error in each magnification is stored in the storage unit 630. For this reason, the transmission electron microscope 100 can accurately perform beam centering.

An image classification method in the transmission electron microscope 100 includes a step of acquiring an initial image captured by the detector 50, a step of calculating an average value M and a standard deviation S of pixel values of a plurality of pixels composing the initial image, a step of acquiring information of an average value Md and a standard deviation Sd of pixel values of a plurality of pixels composing a dark image captured in a state in which no electron beam is detected by the detector 50, and a step of classifying the initial image based on the average value M and the standard deviation S of the pixel values of the initial image and the average value Md, and the standard deviation Sd of the pixel values of the dark image. For this reason, in the image classification method in the transmission electron microscope 100, initial images can be classified based on the average value M and the standard deviation S of pixel values of initial images and the average value Md and the standard deviation Sd of pixel values of dark images. Accordingly, initial images can be classified without depending on user's experiences.

5. Modified Example

5.1. First Modified Example

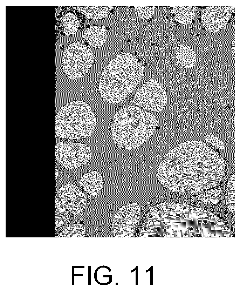

FIG. 11 illustrates a modified example of a judgment method using a coefficient of variation.

In the embodiment described above, as illustrated in FIG. 8, in the process in Step S110, an initial image is classified as a beam image when "CV > 0.522" is satisfied. However, as illustrated in FIG. 11, when a grid part through which an electron beam is not transmitted is included in a sample image, the coefficient of variation becomes high, and "CV > 0.522" is satisfied, and there is a likelihood that the sample image illustrated in FIG. 11 is classified as a beam image.

Here, as illustrated in FIG. 5, in a beam image, the more the beam is narrowed down, the higher the coefficient of variation becomes. Thus, while the beam is narrowed down (the beam diameter is decreased), a change in the coefficient of variation is monitored. When the coefficient of variation becomes larger as the beam is narrowed down, the image can be classified as a beam image. In addition, at this time, in consideration of the size of an area acquired by excluding a black area through which an electron beam is not transmitted, the beam diameter may be changed inside this area.

For example, after "Yes" is judged in Step S110 illustrated in FIG. 8, the arithmetic unit 602 may perform a process of judging whether or not the coefficient of variation CV of an initial image becomes higher in accordance with a decrease in the beam diameter. When the coefficient of variation CV becomes higher, the arithmetic unit 602 classifies the image into a beam image (Step S114). When the coefficient of variation CV becomes not higher, the image is classified as a vacuum region image or a sample image (Step S112). In this way, the likelihood of erroneous judgment can be reduced.

5.2. Second Modified Example

In the embodiment described above, as illustrated in FIG. 8, the control device 60, after the image classification process S2, performs the spotting process in Step S121, the spotting process in Step S122, and the beam centering process of Step S126 and adjusts the electron beam such that the center of the electron beam is positioned at the center of an image captured by the detector 50.

In contrast to this, for example, after the image classification process S2, the spotting process in Step S121, and the spotting process in Step S122 are performed, correction of astigmatism may be performed using the acquired spot image. By correcting astigmatism, a beam having an elliptical shape can be converted into a perfect circle. Although not illustrated in the drawing, the transmission electron microscope 100 includes an astigmatism correcting device for correcting astigmatism. The correction of astigmatism can be automated using a known technique. Thus, after the image classification process S2, the spotting process in Step S121, and the spotting process in Step S122 are performed, by executing a known automatic aberration correction for the spot image, astigmatism can be automatically corrected from the initial image.

In addition, for example, when the initial image is classified as a vacuum region image or a sample image using the image classification process S2, the arithmetic unit 602 may classify the initial image into a vacuum region image or a sample image based on the standard deviation S of the initial image. The standard deviation of pixel values of a sample image is larger than the standard deviation of pixel values of a vacuum region. Thus, the initial image can be classified as a vacuum region image or a sample image based on whether or not the standard deviation S of the initial image is larger than a predetermined judgment value.

Here, when the initial image is classified as a sample image, focus adjustment can be performed using the sample image. The focus adjustment can be automated using a sample image by using a known technique. Thus, by performing the image classification process S2, the process of judging whether an initial image is a sample image based on the standard deviation of the initial image, and a focus adjusting process using a sample image when an initial image is classified as a sample image, focus adjustment can be automatically performed using the initial image.

In addition, since height adjustment of the specimen 2 also can be automated using a sample image by using a known technique, similarly, when an initial image is classified as a sample image in the image classification process S2 and the process of judging whether an initial image is a sample image based on the standard deviation of the initial image, by performing a focus adjustment process using the sample image, focus adjustment can be automatically performed using the initial image. In this way, in the transmission electron microscope 100, the arithmetic unit 602 automatically classifies images, and thus, before adjustment of the optical system is automatically performed, an image required for adjustment can be automatically prepared. Accordingly, user's burden can be alleviated.

### 5.3. Third Modified Example

An optimization process may be performed for an image captured by the detector 50. By performing the optimization process, noise inherent to the detector 50 and the electron beam induce scintillation, and the artifacts occurring before the electron beam reaches the detector 50 can be eliminated. In accordance with this, a correct coefficient of variation can be calculated. Hereinafter, the optimization process will be described.

An image acquired in a state in which no electron beam has been detected at an exposure time y1 seconds by the detector 50 will be denoted by $D_{y1}$. An image acquired in a state in which no electron beam has been detected at an exposure time y2 seconds by the detector 50 will be denoted by $D_{y2}$. In the same order, an image $D_{yi}$ is acquired for every exposure time yi (i = 1, 2, 3, 4, ..., n) seconds. Based on the image $D_{yi}$, an image Dz for an arbitrary exposure time z seconds and an average luminance value $D_{z\_mean}$ thereof are generated.

Next, an image acquired by causing an electron beam to be incident at an exposure time y1 seconds and enlarging the electron beam to be larger than a range that can be read by a sensor of the detector 50 in a vacuum region is denoted by $C_{y1}$. In the same order, an image $C_{yi}$ (i = 1, 2, 3, 4, ..., n) is acquired for every exposure time yi (i = 1, 2, 3, 4, ..., n) seconds. Up to this point, the processes serve as pre-processing.

An image acquired at an exposure time x seconds is denoted by A, and an average luminance value at that time is denoted by $A_{mean}$. Here, an image B is generated. The image B is an image generated using an image $C_{x1}$ acquired in a uniformly-illuminated state in a vacuum region having an average luminance value closest to $A_{mean}$ and an image $C_{x2}$ acquired in a uniformly-illuminated state in a vacuum region having an average luminance value that is second closest to $A_{mean}$. In order to eliminate effects of the detector 50 on the image, $D_x$ and $D_{x\_mean}$ are eliminated through calculation. An equation for generating the image B is represented in the following Equation.

$$B = \begin{pmatrix} b(0,0) & \cdots & b(width-1,0) \\ \vdots & \ddots & \vdots \\ b(0, height-1) & \cdots & b(width-1, height-1) \end{pmatrix} / 2$$

$$b(0,0) = (\frac{X_{Cx1(0,0)} - X_{Dx(0,0)}}{Cx1_{mean} - Dx_{mean}} + \frac{X_{Cx2(0,0)} - X_{Dx(0,0)}}{Cx2_{mean} - Dx_{mean}})$$

$$b(0, height-1) = (\frac{X_{Cx1(0,height-1)} - X_{Dx(0,height-1)}}{Cx1_{mean} - Dx_{mean}} + \frac{X_{Cx2(0,height-1)} - X_{Dx(0,height-1)}}{Cx2_{mean} - Dx_{mean}})$$

$$b(width-1,0) = (\frac{X_{Cx1(width-1,0)} - X_{Dx(widh-1,0)}}{Cx1_{mean} - Dx_{mean}} + \frac{X_{Cx2(width-1,0)} - X_{Dx(widh-1,0)}}{Cx2_{mean} - Dx_{mean}})$$

$$b(width - 1, height - 1)$$

$$= (\frac{X_{Cx1(width-1,height-1)} - X_{Dx(width-1,height-1)}}{Cx1_{mean} - Dx_{mean}}$$

$$+ \frac{X_{Cx2(width-1,height-1)} - X_{Dx(width-1,height-1)}}{Cx2_{mean} - CDx_{mean}})$$

In addition, $C_{x1mean}$ is an average luminance value of the image $C_{x1}$, and $C_{x2mean}$ is an average luminance value of the image $C_{x2}$. $X_{Dx(n1, n2)}$ is a luminance value of the image Dx at coordinates (n1, n2) (n1 = 0, 1, ..., width-1, n2 = 0, 1, ..., height-1). $X_{Cx1(n1, n2)}$ is a luminance value of the image $C_{x1}$ at coordinates (n1, n2) (n1 = 0, 1, ..., width-1, n2 = 0, 1, ..., height-1). $X_{Cx2(n1, n2)}$ is a luminance value of the image $C_{x2}$ at coordinates (n1, n2) (n1 = 0, 1, ..., width-1, n2 = 0, 1, ..., height-1). In addition, width represents a width of the image, and height represents a height of the image.

Based on the image B generated using the equation described above, an image A' acquired by optimizing the image A is generated. The image A' can be represented in the following equation.

$$A' = A - D_x - (A_{mean} - D_{x_{mean}}) \times B + A_{mean} - D_{x_{mean}}$$

A' represents an image after optimization, and A represents the original image. Dx is an image acquired in a state in which no electron beam is incident. $A_{mean}$ is an average luminance value of the image A, and $D_{x\_mean}$ is an average luminance value of the image D.

First, by subtracting the image $D_x$ acquired in a state in which no electron beam is detected by the detector 50, the influence of noise from the detector 50 is eliminated. Next, in order to optimize the image B for the image A, the average luminance value $D_{x\_meam}$ of Dx acquired in a state in which no electron beam is detected by the detector 50 is subtracted from the average luminance value $A_{mean}$ of A, the image B is multiplied by a result thereof, and a result thereof is subtracted from the image A. In accordance with this, noise that is originally included in the detector 50 and the electron beam induce scintillation, and the artifacts occurring before the electron beam reaches the detector 50 can be eliminated.

Thereafter, by adding $A_{mean}$, the brightness of the original image A subtracted from the image B is reproduced. Finally, by subtracting $D_{x\_mean}$, noise of the detector 50 included in $A_{mean}$ is eliminated, and the image A' is generated.

By calculating a coefficient of variation from the generated image A', information acquired from the electron beam can be accurately acquired, and the coefficient of variation can be accurately calculated. In addition, this process is not limited to the calculation of a coefficient of variation, and, by applying this process to all the images, pure information acquired from an electron beam can be acquired as an image.

In addition, the embodiment and the modified examples described above are examples, and the invention is not limited thereto. For example, each embodiment and each modified example can be appropriately combined.

The invention is not limited to the above-described embodiments, and various modifications can be made. For example, the invention includes configurations that are substantially the same as the configurations described in the embodiments. Substantially same configurations mean configurations having the same functions, and methods, for example. The invention also includes configurations obtained by replacing non-essential elements of the configurations described in the embodiments with other elements. The invention further includes configurations obtained by adding known art to the configurations described in the embodiments.

**Claims**

1.  A transmission electron microscope comprising:

    an illumination system that illuminates a specimen with an electron beam;
    an imaging system that forms an image using the electron beam that has been transmitted through the specimen;
    a detector that captures the image formed by the imaging system; and
    an arithmetic unit that classifies the image captured by the detector,
    the arithmetic unit performing:

    a process of acquiring a first image captured by the detector;
    a process of calculating an average value and a standard deviation of first pixel values of a plurality of first pixels composing the first image;

a process of acquiring information of an average value and a standard deviation of second pixel values of a plurality of second pixels composing a second image captured in a state in which no electron beam is detected by the detector; and

a process of classifying the first image based on the average value and the standard deviation of the first pixel values and the average value and the standard deviation of the second pixel values.

2.  The transmission electron microscope according to claim 1,
    wherein the arithmetic unit, in the process of classifying the first image, when the arithmetic unit judges that the average value of the first pixel values is larger than a sum of the average value and the standard deviation of the second pixel values, performs a process of judging whether or not the first image is a beam image based on a coefficient of variation of the first pixel values.

3.  The transmission electron microscope according to claim 2,
    wherein, in the process of judging whether or not the first image is a beam image, the arithmetic unit judges whether or not the first image is a beam image by comparing the coefficient of variation of the first pixel values with a judgment value that is based on a coefficient of variation of pixel values of a plurality of pixels composing an image which includes an entire contour of the electron beam and in which a diameter of the electron beam is maximum.

4.  The transmission electron microscope according to claim 3,
    wherein, in the process of judging whether or not the first image is a beam image, the arithmetic unit classifies the first image into a beam image when the arithmetic unit judges that the coefficient of variation of the first pixel values is larger than the judgment value.

5.  The transmission electron microscope according to any one of claims 1 to 4,
    wherein, in the process of classifying the first image, the arithmetic unit:

    judges whether or not the standard deviation of the first pixel values is larger than a sum of the average value of the first pixel values and the standard deviation of the second pixel values when the arithmetic unit judges that the average value of the first pixel values is not larger than the sum of the average value and the standard deviation of the second pixel values;
    classifies the first image into a beam image when the arithmetic unit judges that the standard deviation of the first pixel values is larger than the sum of the average value of the first pixel values and the standard deviation of the second pixel values; and
    classifies the first image into an image captured in a state in which no electron beam is detected by the detector when the arithmetic unit judges that the standard deviation of the first pixel values is not larger than the sum of the average value of the first pixel values and the standard deviation of the second pixel values.

6.  The transmission electron microscope according to any one of claims 2 to 5, further comprising:

    a storage unit; and
    a control unit that controls the illumination system,
    wherein the illumination system includes a deflector that deflects the electron beam,
    wherein the storage unit stores first calibration data representing a relation between an amount of movement of a beam on an image and an amount of control of the deflector, and
    wherein the arithmetic unit performs:

    a process of calculating a first positional deviation amount between a position of the electron beam on the first image and a center of the first image when the first image is classified as a beam image;
    a process of including magnification information of the first image in the first calibration data;
    a process of obtaining the amount of control of the deflector from the first positional deviation amount using the first calibration data including the magnification information of the first image;
    a process of calculating an error in a magnification ratio of the first image based on a position of the electron beam at the time when the control unit caused the deflector to deflect the electron beam based on the amount of control of the deflector to move the electron beam; and
    a process of storing information of the calculated error in the storage unit.

7.  The transmission electron microscope according to claim 6,
    wherein the arithmetic unit performs:

a process of generating second calibration data by including the information of the error in the first calibration data including the magnification information of the first image;

a process of calculating a second positional deviation amount between a position of the electron beam and the center of the first image; and

a process of obtaining the amount of control of the deflector from the second positional deviation amount using the second calibration data, and

wherein the control unit performs a process of causing the deflector to deflect the electron beam based on the amount of control of the deflector.

8. The transmission electron microscope according to claim 6 or 7, wherein the storage unit stores the information of the error in each magnification.

9. An image classification method in a transmission electron microscope including:

an illumination system that illuminates a specimen with an electron beam;

an imaging system that forms an image using the electron beam that has been transmitted through the specimen; and

a detector that captures the image formed by the imaging system,

the image classification method comprising:

a step of acquiring a first image captured by the detector;

a step of calculating an average value and a standard deviation of first pixel values of a plurality of first pixels composing the first image;

a step of acquiring information of an average value and a standard deviation of second pixel values of a plurality of second pixels composing a second image captured in a state in which no electron beam is detected by the detector; and

a step of classifying the first image based on the average value and the standard deviation of the first pixel values and the average value and the standard deviation of the second pixel values.

10. The image classification method according to claim 9,

wherein the step of classifying the first image includes a step of judging whether or not the first image is a beam image based on a coefficient of variation of the first pixel values when the average value of the first pixel values is judged to be larger than a sum of the average value and the standard deviation of the second pixel values.

11. The image classification method according to claim 10,

wherein, in the step of judging whether or not the first image is a beam image, it is judged whether or not the first image is a beam image by comparing the coefficient of variation of the first pixel values with a judgment value that is based on a coefficient of variation of pixel values of a plurality of pixels composing an image which includes an entire contour of the electron beam and in which a diameter of the electron beam is maximum.

12. The image classification method according to claim 11,

wherein, in the step of judging whether or not the first image is a beam image, the first image is classified as a beam image when the coefficient of variation of the first pixel values is judged to be larger than the judgment value.

13. The image classification method according to any one of claims 9 to 12,

wherein the step of classifying the first image includes:

a step of judging whether or not the standard deviation of the first pixel values is larger than a sum of the average value of the first pixel values and the standard deviation of the second pixel values when the average value of the first pixel values is judged to be no larger than the sum of the average value and the standard deviation of the second pixel values;

a step of classifying the first image into a beam image when the standard deviation of the first pixel values is judged to be larger than the sum of the average value of the first pixel values and the standard deviation of the second pixel values; and

a step of classifying the first image into an image captured in a state in which no electron beam is detected by the detector when the standard deviation of the first pixel values is judged to be no larger than the sum of the average value of the first pixel values and the standard deviation of the second pixel values.

14. An electron beam adjusting method including the image classification method according to any one of claims 10 to 13, the electron beam adjusting method comprising:

a step of calculating a first positional deviation amount between a position of the electron beam on the first image and a center of the first image when the first image is classified as a beam image;

a step of including magnification information of the first image in first calibration data representing a relation between an amount of movement of a beam on an image and an amount of control of a deflector that deflects the electron beam;

a step of obtaining the amount of control of the deflector from the first positional deviation amount using the first calibration data including the magnification information of the first image; and

a step of calculating an error in a magnification ratio of the first image based on a position of the electron beam at the time when the deflector is caused to deflect the electron beam based on the obtained amount of control of the deflector to move the electron beam.

15. The electron beam adjusting method according to claim 14, further comprising:

a step of generating second calibration data by including information of the error in the first calibration data including the magnification information of the first image;

a step of calculating a second positional deviation amount between a position of the electron beam and the center of the first image;

a step of obtaining the amount of control of the deflector from the second positional deviation amount using the second calibration data; and

a step of causing the deflector to deflect the electron beam based on the amount of control of the deflector.

FIG. 1

FIG. 2

DARK IMAGE     VACUUM-REGION IMAGE     SAMPLE IMAGE

BEAM IMAGE

FIG. 3

M>Md+Sd

True              False

CV>0.522              S>M+Sd

False    True        True    False

FIG. 4

| DIAMETER 1.06 | DIAMETER 1.00 | DIAMETER 0.50 |
|---|---|---|

| AVERAGE VALUE | : 0.882 | AVERAGE VALUE | : 0.785 | AVERAGE VALUE | : 0.197 |
| STANDARD DEVIATION | : 0.321 | STANDARD DEVIATION | : 0.410 | STANDARD DEVIATION | : 0.397 |
| COEFFICIENT OF VARIATION | : 0.365 | COEFFICIENT OF VARIATION | : 0.522 | COEFFICIENT OF VARIATION | : 2.021 |

FIG. 5

FIG. 6

FIG. 7

START

S2

S100
ACQUIRE INITIAL IMAGE

S102
CALCULATE AVERAGE VALUE M

S104
ACQUIRE INFORMATION OF AVERAGE
VALUE Md AND STANDARD DEVIATION Sd

S106
$M > Md + Sd$?   No

Yes   S108
CALCULATE COEFFICIENT OF
VARIATION CV

S116
CALCULATE STANDARD
DEVIATION S

S110
$CV > 0.522$?   Yes   Yes

S118
$S > M + Sd$?

No   S112
CLASSIFY INITIAL IMAGE INTO
VACUUM-REGION IMAGE OR
SAMPLE IMAGE

S114
CLASSIFY INITIAL IMAGE
INTO BEAM IMAGE

No   S120
CLASSIFY INITIAL IMAGE
INTO DARK IMAGE

S122
PERFORM SPOTTING

S121
PERFORM SPOTTING

S124
No   $F = 1$?

Yes

S126
PERFORM BEAM
CENTERING

END

FIG. 8

23

```
        ┌─────────────────────────┐
        │     SPOTTING START       │
        └─────────────────────────┘
                    │
                    ▼                    ⌐S200
        ┌─────────────────────────┐
        │ SET MAGNIFICATION TO LOWEST │
        │      MAGNIFICATION       │
        └─────────────────────────┘
                    │
                    ▼            ⌐S202
              ╱────────────╲              Yes
        ╱   HAS ELECTRON      ╲──────────────┐
        ╲ BEAM BEEN CONVERTED INTO SPOT ╱     │
              ╲    SHAPE?    ╱                 │
                    │ No         ⌐S204         │
                    ▼                          │
        ┌─────────────────────────┐           │
        │ SET NEUTRAL VALUE TO DEFLECTOR │     │
        └─────────────────────────┘           │
                    │                          │
                    ▼            ⌐S206         │
              ╱────────────╲              Yes  │
        ╱   HAS ELECTRON      ╲──────────────┤
        ╲ BEAM BEEN CONVERTED INTO SPOT ╱     │
              ╲    SHAPE?    ╱                 │
                    │ No         ⌐S208         │
                    ▼                          │
        ┌─────────────────────────┐           │
        │ CHANGE EXCITATION OF CONDENSER LENS │ │
        └─────────────────────────┘           │
                    │                          │
                    ▼            ⌐S210         │
              ╱────────────╲              Yes  │
        ╱   HAS ELECTRON      ╲──────────────┤
        ╲ BEAM BEEN CONVERTED INTO SPOT ╱     │
              ╲    SHAPE?    ╱                 │
                    │ No    ⌐S212      ⌐S214   │
                    ▼                          ▼
        ┌──────────────┐          ┌──────────────┐
        │     F=0      │          │     F=1      │
        └──────────────┘          └──────────────┘
                    │                          │
                    ▼◄─────────────────────────┘
        ┌─────────────────────────┐
        │      SPOTTING END        │
        └─────────────────────────┘
```

FIG. 9

```
        ┌─────────────────────┐
        │   BEAM CENTERING    │
        │       START         │
        └─────────────────────┘
                   │
                   ▼                              S300
        ┌─────────────────────────────────┐
        │ ACQUIRE MAGNIFICATION INFORMATION│
        │        OF SPOT IMAGE             │
        └─────────────────────────────────┘
                   │                              S302
                   ▼
        ┌─────────────────────────────────┐
        │     ACQUIRE CALIBRATION DATA     │
        └─────────────────────────────────┘
                   │                              S303
                   ▼
        ┌─────────────────────────────────────┐
        │    GENERATE CALIBRATION DATA         │
        │ INCLUDING MAGNIFICATION INFORMATION  │
        └─────────────────────────────────────┘
                   │                       S304
                   ▼                              Yes
        ◇ IS ERROR INFORMATION PRESENT? ◇──────────┐
                   │ No                   S306      │
                   ▼                               │
        ┌─────────────────────────────────┐        │
        │   CALCULATE AMOUNT OF DEVIATION  │        │
        │    FROM IMAGE CENTER OF BEAM     │        │
        └─────────────────────────────────┘        │
                   │                       S308     │
                   ▼                               │
        ┌─────────────────────────────────┐        │
        │        CALCULATE AMOUNT          │        │
        │      OF CONTROL OF DEFLECTOR     │        │
        └─────────────────────────────────┘        │
                   │                       S310     │
                   ▼                               │
        ┌─────────────────────────────────┐        │
        │     MOVE BEAM USING DEFLECTOR    │        │
        └─────────────────────────────────┘        │
                   │                   S312         │
      Yes          ▼                               │
    ┌──── ◇ HAS BEAM BEEN MOVED TO IMAGE CENTER? ◇  │
    │              │ No                   S314       │
    │              ▼                               │
    │   ┌─────────────────────────────────┐        │
    │   │    IDENTIFY POSITION OF BEAM     │        │
    │   └─────────────────────────────────┘        │
    │              │                       S316     │
    │              ▼                               │
    │   ┌─────────────────────────────────┐        │
    │   │ CALCULATE ERROR IN MAGNIFICATION │        │
    │   │            RATIO                 │        │
    │   └─────────────────────────────────┘        │
    │              │                       S318     │
    │              ▼                               │
    │   ┌─────────────────────────────────┐        │
    │   │      STORE ERROR INFORMATION     │        │
    │   └─────────────────────────────────┘        │
    │              │                               │
    │              ▼◄──────────────────────────────┘
    │              │                       S320
    │   ┌─────────────────────────────────┐
    │   │ GENERATE CALIBRATION DATA INCLUDING│
    │   │    ERROR IN MAGNIFICATION RATIO  │
    │   └─────────────────────────────────┘
    │              │                       S322
    │              ▼
    │   ┌─────────────────────────────────┐
    │   │   CALCULATE AMOUNT OF DEVIATION  │
    │   │    FROM IMAGE CENTER OF BEAM     │
    │   └─────────────────────────────────┘
    │              │                       S324
    │              ▼
    │   ┌─────────────────────────────────┐
    │   │        CALCULATE AMOUNT          │
    │   │      OF CONTROL OF DEFLECTOR     │
    │   └─────────────────────────────────┘
    │              │                       S326
    │              ▼
    │   ┌─────────────────────────────────┐
    │   │     MOVE BEAM USING DEFLECTOR    │
    │   └─────────────────────────────────┘
    │              │
    │              ▼
    └──────►┌─────────────────────┐
           │  BEAM CENTERING END  │
           └─────────────────────┘
```

FIG. 10

FIG. 11

Europäisches
Patentamt

European
Patent Office

Office européen
des brevets

# EUROPEAN SEARCH REPORT

**Application Number**

EP 25 16 4549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 091 505 A1 (JEOL LTD [JP]) 9 November 2016 (2016-11-09) * paragraph [0006] * * paragraph [0054] * * paragraph [0068] * * paragraph [0074] * * paragraph [0077] - paragraph [0080] * | 1-15 | INV. H01J37/147 H01J37/244 H01J37/26 |
| A | EP 3 779 403 A1 (HITACHI HIGH TECH CORP [JP]) 17 February 2021 (2021-02-17) * paragraph [0066] - paragraph [0073] * | 1-15 | |
| A | JP 2005 216645 A (JEOL LTD) 11 August 2005 (2005-08-11) * paragraph [0013] - paragraph [0015] * * paragraph [0066] - paragraph [0069] * | 1-15 | |
| A | CA 2 839 778 C (UNIV LAVAL [CA]) 29 October 2019 (2019-10-29) * Summary * | 1-15 | |
|  |  |  | TECHNICAL FIELDS SEARCHED (IPC) |
|  |  |  | H01J |

The present search report has been drawn up for all claims

| Place of search | Date of completion of the search | Examiner |
|---|---|---|
| Munich | 7 August 2025 | Giovanardi, Chiara |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 4549

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2025

| Patent document cited in search report | | Publication date | Patent family member(s) | | Publication date |
|---|---|---|---|---|---|
| EP 3091505 | A1 | 09-11-2016 | EP | 3091505 A1 | 09-11-2016 |
| | | | JP | 6518504 B2 | 22-05-2019 |
| | | | JP | 2016213054 A | 15-12-2016 |
| EP 3779403 | A1 | 17-02-2021 | EP | 3779403 A1 | 17-02-2021 |
| | | | PT | 3779403 T | 10-07-2024 |
| | | | WO | 2019186976 A1 | 03-10-2019 |
| JP 2005216645 | A | 11-08-2005 | NONE | | |
| CA 2839778 | C | 29-10-2019 | CA | 2839778 A1 | 03-01-2013 |
| | | | US | 2014126790 A1 | 08-05-2014 |
| | | | WO | 2013000081 A1 | 03-01-2013 |

EPO FORM P0459

For more details about this annex : see Official Journal of the European Patent Office, No. 12/82

## EP 4 629 278 A1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002134048 A